# EUROPEAN PATENT APPLICATION

(11) **EP 3 709 771 A1**
(43) Date of publication of application: **16.09.2020**
(21) Application number: 18876459.1
(22) Date of filing: 06.11.2018
(51) Int. Cl.: H05B 33/10, H01L 51/50

(54) **COLOR TEMPERATURE ADJUSTMENT METHOD AND METHOD OF MANUFACTURING ORGANIC EL ELEMENT**

(30) Priority: 08.11.2017 JP 2017215644
(71) Applicant: Sumitomo Chemical Co., Ltd., Tokyo 104-8260 (JP)
(72) Inventor: KAIHO Akio, Niihama-shi Ehime 792-0015 (JP)
(74) Representative: J A Kemp LLP
(86) International application number: PCT/JP2018/041210
(87) International publication number: WO 2019/093335

(57) **Abstract**

A method for producing an organic light-emitting diode (1) includes a step of adjusting an integrated illuminance of light which is a product of an illuminance of light that does not include light having a wavelength range of 500 nm or less emitted to a light emitting layer (11) and an emission time of the light until formation of a cathode layer (17) starts in a second forming step after the light emitting layer (11) is formed in a first forming step.

## Description

### Technical Field

The present invention relates to a method for adjusting a color temperature and a method for producing an organic light-emitting diode.

### Background Art

Regarding a conventional method for producing an organic device, for example, a method described in Patent Literature 1 is known. In the method for producing an organic device described in Patent Literature 1, a light emitting layer containing an arylamine compound is formed into a wet film under a light environment that does not include a wavelength of 500 nm or less.

### Citation List

### Patent Literature

[Patent Literature 1] PCT International Publication No. WO2010/104184

### Summary of Invention

### Technical Problem

When an organic light-emitting diode is used for a lighting device and the like, a color temperature is adjusted to a neutral white color type, a warm color type, or the like. In the related art, the color temperature of the organic light-emitting diode has been adjusted by changing a film thickness of a light emitting layer or changing a formulation proportion of an ink contained in the light emitting layer. Therefore, in the related art, the burden of an operation related to adjustment of the color temperature has been large.

An object of one aspect of the present invention is to provide a method for adjusting a color temperature and a method for producing an organic light-emitting diode through which it is possible to easily adjust the color temperature.

### Solution to Problem

A method for adjusting a color temperature according to one aspect of the present invention is a method for adjusting a color temperature of an organic light-emitting diode formed by a method including a first forming step of forming two or more organic functional layers including at least a light emitting layer on a first electrode layer and a second forming step of forming a second electrode layer on the organic functional layer, wherein, until formation of the second electrode layer starts in the second forming step after the light emitting layer is formed in the first forming step, an integrated illuminance of light which is a product of an illuminance of light that does not include light having a wavelength range of 500 nm or less emitted to the light emitting layer and an emission time of the light is adjusted.

In the method for adjusting a color temperature according to one aspect of the present invention, until formation of the second electrode layer starts in the second forming step after the light emitting layer is formed in the first forming step, the integrated illuminance of yellow light which is a product of the illuminance of light (hereinafter referred to as yellow light) that does not include light having a wavelength range of 500 nm or less emitted to the light emitting layer and the emission time of yellow light is adjusted. When yellow light is emitted to the light emitting layer (including another organic functional layer provided between the light emitting layer and the first electrode layer), properties (characteristics) of the layers change. In this case, due to the change in the properties, the luminance of a layer that emits red light can be reduced. Thereby, it is possible to increase the color temperature of the organic light-emitting diode. Therefore, in the method for adjusting a color temperature, the color temperature can be adjusted by adjusting the integrated illuminance of yellow light without changing the film thickness of the light emitting layer or changing a formulation proportion of an ink contained in the light emitting layer. Therefore, in the method for adjusting a color temperature of the present invention, it is possible to easily adjust the color temperature.

In one embodiment, the integrated illuminance may be 100 lx·hrs or more and 500,000 lx·hrs or less. The integrated illuminance is a cumulative illuminance value with respect to the illuminance [lx] and the emission time [hrs] of light. In this method, it is possible to appropriately adjust the color temperature of the organic light-emitting diode.

A method for producing an organic light-emitting diode according to one aspect of the present invention includes a first forming step of forming two or more organic functional layers including at least a light emitting layer on a first electrode layer and a second forming step of forming a second electrode layer on the organic functional layer, and until formation of the second electrode layer starts in the second forming step after the light emitting layer is formed in the first forming step, an integrated illuminance of the light which is a product of an illuminance of light that does not include light having a wavelength range of 500 nm or less emitted to the light emitting layer and an emission time of the light is adjusted.

The method for producing an organic light-emitting diode according to one aspect of the present invention includes a step of adjusting an integrated illuminance of yellow light which is a product of the illuminance of light (hereinafter referred to as yellow light) that does not include light having a wavelength range of 500 nm or less emitted to the light emitting layer and the emission time of the yellow light until formation of the second electrode layer starts in the second forming step after the light emitting layer is formed in the first forming step. When yellow light is emitted to the light emitting layer (including another organic functional layer provided between the light emitting layer and the first electrode layer), properties (characteristics) of the layers change. In this case, due to the change in the properties, the luminance of a layer that emits red light can be reduced. Thereby, it is possible to increase the color temperature of the organic light-emitting diode. Therefore, in the method for producing an organic light-emitting diode, the color temperature can be adjusted by adjusting the integrated illuminance of yellow light without changing the film thickness of the light emitting layer or changing a formulation proportion of an ink contained in the light emitting layer. Therefore, in the method for producing an organic light-emitting diode, it is possible to easily adjust the color temperature.

The method for producing an organic light-emitting diode according to one aspect of the present invention includes a first forming step of forming two or more organic functional layers including at least a light emitting layer on a first electrode layer and a second forming step of forming a second electrode layer on the organic functional layer, and until formation of the second electrode layer starts in the second forming step after the light emitting layer is formed in the first forming step, light having a wavelength range of 500 nm or less is not emitted to the light emitting layer.

In the method for producing an organic light-emitting diode according to one aspect of the present invention, until formation of the second electrode layer starts in the second forming step after the light emitting layer is formed in the first forming step, light having a wavelength range of 500 nm or less is not emitted to the light emitting layer. That is, light (hereinafter referred to as yellow light) that does not have at least a wavelength range of 500 nm or less is emitted to the light emitting layer. When yellow light is emitted to the light emitting layer (including another organic functional layer provided between the light emitting layer and the first electrode layer), properties (characteristics) of the layers change. In this case, due to the change in the properties, the luminance of a layer that emits red light can be reduced. Thereby, it is possible to increase the color temperature of the organic light-emitting diode. Therefore, in the method for producing an organic light-emitting diode, the color temperature can be adjusted without emitting light having a wavelength range of 500 nm or less without changing the film thickness of the light emitting layer or changing a formulation proportion of an ink contained in the light emitting layer. Therefore, in the method for producing an organic light-emitting diode, it is possible to easily adjust the color temperature.

In one embodiment, until formation of the second electrode layer starts in the second forming step after the light emitting layer is formed in the first forming step, a dew point temperature of an atmosphere may be -35°C or lower. In this method, it is possible to appropriately adjust the color temperature of the organic light-emitting diode, and it is possible to reduce deterioration due to water of the organic functional layer including the light emitting layer.

In one embodiment, until formation of the second electrode layer starts in the second forming step after the light emitting layer is formed in the first forming step, an atmosphere may be a dry air atmosphere. In this method, it is possible to appropriately adjust the color temperature of the organic light-emitting diode.

### Advantageous Effects of Invention

According to one aspect of the present invention, it is possible to easily adjust the color temperature.

### Brief Description of Drawings

FIG. 1 is a diagram showing a cross-sectional configuration of an organic light-emitting diode produced by a method for producing an organic light-emitting diode according to one embodiment.
FIG. 2 is a flowchart showing a method for producing an organic light-emitting diode.
FIG. 3 is a diagram showing a relationship between a voltage and a color temperature.

### Description of Embodiments

Exemplary embodiments of the present invention will be described below in detail with reference to the appended drawings. Here, the same or corresponding components are denoted with the same reference numerals in the following description, and redundant descriptions thereof will be omitted.

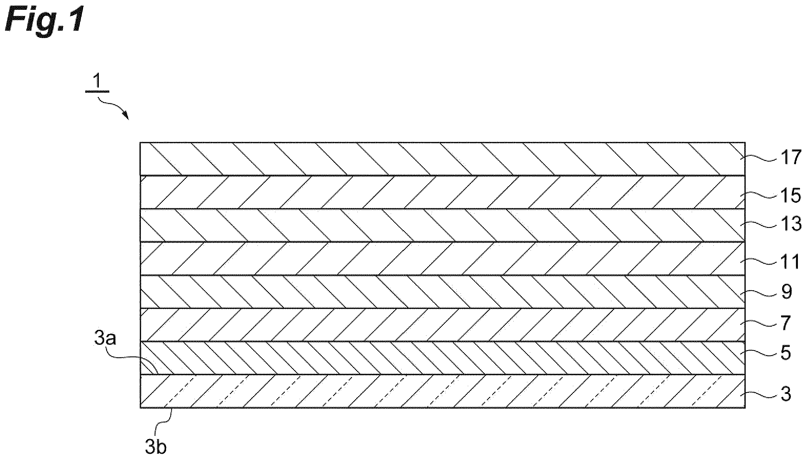

As shown in FIG. 1, an organic light-emitting diode 1 produced by a method for producing an organic light-emitting diode according to one embodiment includes a support substrate 3, an anode layer (first electrode layer) 5, a hole injection layer 7, a hole transport layer (organic functional layer) 9, a light emitting layer (organic functional layer) 11, an electron transport layer (organic functional layer) 13, an electron injection layer (organic functional layer) 15, and a cathode layer (second electrode layer) 17.

### [Support substrate]

The support substrate 3 is formed of a member having translucency with respect to visible light (light with a wavelength of 400 nm to 800 nm). Examples of the support substrate 3 include glass and the like. When the support substrate 3 is glass, the thickness thereof is, for example, 0.05 mm to 1.1 mm. The support substrate 3 may be made of a resin, and may be, for example, a film-like substrate (a flexible substrate and a substrate having flexibility). In this case, the thickness of the support substrate 3 is, for example, 30 µm or more and 500 µm or less. When the support substrate 3 is made of a resin, preferably, the thickness is 45 µm or more in consideration of substrate deflection, wrinkles, and elongation during a continuous roll-to-roll method, and is 125 µm or less in consideration of flexibility.

The support substrate 3 is, for example, a plastic film. Examples of materials of the support substrates 3 include polyether sulfone (PES); polyester resins such as polyethylene terephthalate (PET) and polyethylene naphthalate (PEN); polyolefin resins such as polyethylene (PE), polypropylene (PP), and cyclic polyolefins; polyamide resins; polycarbonate resins; polystyrene resins; polyvinyl alcohol resins; saponified products of ethylene-vinyl acetate copolymers; polyacrylonitrile resins; acetal resins; polyimide resins; and epoxy resins.

Regarding the material of the support substrate 3, among the above resins, a polyester resin or a polyolefin resin is preferable and polyethylene phthalate or polyethylene naphthalate is more preferable because heat resistance thereof is high, the coefficient of linear expansion is low, and the production costs are low. In addition, these resins may be used alone or two or more thereof may be used in combination.

A gas barrier layer or a water barrier layer may be disposed on one main surface 3a of the support substrate 3. The other main surface 3b of the support substrate 3 is a light emitting surface. Here, the support substrate 3 may be a glass substrate or a silicon substrate, or may be a thin film glass. When the support substrate 3 is a thin film glass, preferably, the thickness thereof is 30 µm or more in consideration of strength and is 100 µm or less in consideration of flexibility.

### [Anode layer]

The anode layer 5 is disposed on one main surface 3a of the support substrate 3. An electrode layer exhibiting light transmission is used for the anode layer 5. Regarding an electrode exhibiting light transmission, a thin film made of a metal oxide, a metal sulfide or a metal having high electrical conductivity can be used, and a thin film having high light transmittance is suitably used. For example, thin films made of indium oxide, zinc oxide, tin oxide, indium tin oxide (abbreviation ITO), indium zinc oxide (abbreviation IZO), gold, platinum, silver, copper or the like are used. Among these, a thin film made of ITO, IZO, or tin oxide is suitably used.

Regarding the anode layer 5, a transparent conductive film of an organic material such as polyaniline and derivatives thereof, polythiophene and derivatives thereof may be used. In addition, regarding the anode layer 5, an electrode obtained by patterning the above exemplified metals or metal alloys in a mesh shape or an electrode in which nanowires containing silver are formed into a network shape may be used.

The thickness of the anode layer 5 can be determined in consideration of light transmission, electrical conductivity, and the like. The thickness of the anode layer 5 is generally 10 nm to 10 µm, preferably 10 nm to 1 µm, and more preferably 10 nm to 300 nm.

Examples of a method for forming the anode layer 5 include a dry film forming method such as a vacuum deposition method, a sputtering method, and an ion plating method, and a coating method such as an inkjet method, a slit coating method, a gravure printing method, a screen printing method, and a spray coating method. In addition, in the anode layer 5, additionally, a pattern can be formed using a photolithographic method, a dry etching method, a laser trimming method, or the like. Direct coating is performed on the support substrate 3 using a coating method, and thus a pattern can be formed without using a photolithographic method, a dry etching method, a laser trimming method, or the like.

### [Hole injection layer]

The hole injection layer 7 is disposed on a main surface (side opposite to the surface in contact with the support substrate 3) of the anode layer 5. Examples of materials constituting the hole injection layer 7 include oxides such as vanadium oxide, molybdenum oxide, ruthenium oxide, and aluminum oxide, and a phenylamine compound, a starburst type amine compound, a phthalocyanine compound, amorphous carbon, polyaniline, and polythiophene derivatives such as polyethylene dioxythiophene (PEDOT).

A conventionally known organic material having a charge transporting property can be used as a material of the hole injection layer 7 by combining it with an electron-accepting material. Regarding the electron-accepting material, a heteropoly acid compound or an aryl sulfonic acid can be suitably used.

A heteropoly acid compound has a structure in which a heteroatom is positioned at the center of a molecule, which is represented by a Keggin type or Dawson type chemical structure, and is a polyacid obtained by condensing an isopoly acid, which is an oxyacid of such as vanadium (V), molybdenum (Mo), and tungsten (W), with an oxyacid of a heteroelement. Examples of oxyacids of heteroelements mainly include oxyacids of silicon (Si), phosphorus (P), and arsenic (As). Specific examples of heteropoly acid compounds include phosphomolybdic acid, silicomolybdic acid, phosphotungstic acid, phosphotungstomolybdic acid and silicotungstic acid.

Examples of aryl sulfonic acids include benzenesulfonic acid, tosylic acid, p-styrenesulfonic acid, 2-naphthalenesulfonic acid, 4-hydroxybenzenesulfonic acid, 5-sulfosalicylic acid, p-dodecylbenzenesulfonic acid, dihexylbenzenesulfonic acid, 2,5-dihexylbenzenesulfonic acid, dibutylnaphthalenesulfonic acid, 6,7-dibutyl-2-naphthalenesulfonic acid, dodecylnaphthalenesulfonic acid, 3-dodecyl-2-naphthalenesulfonic acid, hexylnaphthalenesulfonic acid, 4-hexyl-1-naphthalenesulfonic acid, octylnaphthalenesulfonic acid, 2-octyl-1-naphthalenesulfonic acid, hexylnaphthalenesulfonic acid, 7-hexyl-1-naphthalenesulfonic acid, 6-hexyl-2-naphthalenesulfonic acid, dinonylnaphthalenesulfonic acid, 2,7-dinonyl-4-naphthalenesulfonic acid, dinonylnaphthalenedisulfonic acid, and 2,7-dinonyl-4,5-naphthalenedisulfonic acid. A heteropoly acid compound and an aryl sulfonic acid may be used in combination.

The thickness of the hole injection layer 7 is 5 nm or more and 500 nm or less, and preferably 5 nm or more and 300 nm or less.

The hole injection layer 7 is formed by, for example, a coating method using a coating solution containing the above materials.

Examples of coating methods include a spin coating method, a casting method, a microgravure coating method, a gravure coating method, a bar coating method, a roll coating method, a wire bar coating method, a dip coating method, a spray coating method, a screen printing method, a flexographic printing method, an offset printing method, and an inkjet printing method. The hole injection layer 7 can be formed by applying a coating solution onto the anode layer 5 using one of these coating methods.

### [Hole transport layer]

The hole transport layer 9 is disposed on a main surface (surface opposite to the surface in contact with the anode layer 5) of the hole injection layer 7. Regarding materials of the hole transport layer 9, known hole transport materials can be used. Examples of materials of the hole transport layer 9 include polyvinyl carbazole or derivatives thereof, polysilane or derivatives thereof, polysiloxanes having an aromatic amine in a side chain or a main chain or derivatives thereof, pyrazoline or derivatives thereof, arylamine or derivatives thereof, stilbene or derivatives thereof, triphenyldiamine or derivatives thereof, polyaniline or derivatives thereof, polythiophene or derivatives thereof, polyarylamine or derivatives thereof, polypyrrole or derivatives thereof, poly(p-phenylene vinylene) or derivatives thereof, and poly(2,5-thienylenevinylene) or derivatives thereof.

The optimum value of the thickness of the hole transport layer 9 differs depending on materials used, and is appropriately set so that a drive voltage and luminous efficiency have appropriate values. The thickness of the hole transport layer 9 is, for example, 1 nm to 1 µm, preferably 2 nm to 500 nm, and more preferably 5 nm to 200 nm.

Examples of a method for forming the hole transport layer 9 include a coating method using a coating solution containing the above materials. Examples of a coating method include a method exemplified for the hole injection layer 7. Any solvent for a coating solution may be used as long as it dissolves the above material, and examples thereof include chlorine-containing solvents such as chloroform, methylene chloride, and dichloroethane, ether solvents such as tetrahydrofuran, aromatic hydrocarbon solvents such as toluene and xylene, ketone solvents such as acetone, and methyl ethyl ketone, and ester solvents such as ethyl acetate, butyl acetate, and ethyl cellosolve acetate.

### [Light emitting layer]

The light emitting layer 11 is disposed on a main surface (surface opposite to the surface in contact with the hole injection layer 7) of the hole transport layer 9. The light emitting layer 11 generally contains an organic material that mainly emits fluorescence and/or phosphorescence or the organic material and a dopant material for a light emitting layer that assists the organic material. For example, the dopant material for a light emitting layer is added to improve luminous efficiency or change a light emission wavelength. Here, the organic material may be a low-molecular-weight compound or a high-molecular-weight compound. Examples of light-emitting materials constituting the light emitting layer 11 include an organic material that mainly emits fluorescence and/or phosphorescence and a dopant material for a light emitting layer such as the following dye materials, metal complex materials, and polymeric materials.

### (Dye materials)

Examples of dye materials include cyclopentamine and derivatives thereof, tetraphenylbutadiene and derivatives thereof, triphenylamine and derivatives thereof, oxadiazole and derivatives thereof, pyrazoloquinoline and derivatives thereof, distyrylbenzene and derivatives thereof, distyrylarylene and derivatives thereof, pyrrole and derivatives thereof, thiophene compounds, pyridine compounds, perinone and derivatives thereof, perylene and derivatives thereof, oligothiophene and derivatives thereof, oxadiazole dimer, pyrazoline dimer, quinacridone and derivatives thereof, and coumarin and derivatives thereof.

### (Metal complex material)

Examples of metal complex materials include metal complexes which contains a rare earth metal such as Tb, Eu, and Dy or Al, Zn, Be, Pt, or Ir as a central metal, and have an oxadiazole, thiadiazole, phenylpyridine, phenylbenzimidazole, or quinoline structure or the like in a ligand. Examples of metal complexes include metal complexes that emit light in a triplet excited state such as iridium complexes and platinum complexes, aluminum quinolinol complexes, benzoquinolinol beryllium complexes, benzoxazolyl zinc complexes, benzothiazole zinc complexes, azomethyl zinc complexes, porphyrin zinc complexes, and phenanthroline europium complexes.

### (Polymeric materials)

Examples of polymeric materials include polyparaphenylene vinylene and derivatives thereof, polythiophene and derivatives thereof, polyparaphenylene and derivatives thereof, polysilane and derivatives thereof, polyacetylene and derivatives thereof, polyfluorene and derivatives thereof, polyvinyl carbazole and derivatives thereof, and materials obtained by polymerizing the above dye materials or metal complex materials.

### (Dopant materials for light emitting layer)

Examples of dopant materials for a light emitting layer include perylene and derivatives thereof, coumarin and derivatives thereof, rubrene and derivatives thereof, quinacridone and derivatives thereof, squarylium and derivatives thereof, porphyrin and derivatives thereof, styryl dyes, tetracene and derivatives thereof, pyrazolone and derivatives thereof, decacyclene and derivatives thereof, and phenoxazone and derivatives thereof.

The thickness of the light emitting layer 11 is, generally, 2 nm to 200 nm. For example, the light emitting layer 11 is formed by a coating method using a coating solution (for example, an ink) containing the above light-emitting material. A solvent for a coating solution containing a light-emitting material is not limited as long as it dissolves the light-emitting material.

### [Electron transport layer]

The electron transport layer 13 is disposed on a main surface (surface opposite to the surface in contact with the hole transport layer 9) of the light emitting layer 11. Regarding the material of the electron transport layer 13, known electron transport materials are used, and examples thereof include compounds having a condensed aryl ring such as naphthalene and anthracene or derivatives thereof, styryl aromatic ring derivatives represented by 4,4-bis(diphenylethenyl)biphenyl, perylene derivatives, perinone derivatives, coumarin derivatives, naphthalimide derivatives, quinone derivatives such as anthraquinone, naphthoquinone, diphenoquinone, anthraquinodimethane, and tetracyanoanthraquinodimethane, phosphorus oxide derivatives, carbazole derivatives, and indole derivatives, quinolinol complexes such as those of tris(8-quinolinolato) and aluminum(III), hydroxyazole complexes such as hydroxyphenyl oxazole complexes, azomethine complexes, tropolone metal complexes and flavonol metal complexes, and compounds having a heteroaryl ring containing an electron-accepting nitrogen.

The thickness of the electron transport layer 13 is, for example, 1 to 100 nm.

Regarding a method for forming the electron transport layer 13, a vacuum deposition method, a coating method using a coating solution, and the like may be exemplified when a low-molecular-weight electron transport material is used, and a coating method using a coating solution and the like may be exemplified when a high-molecular-weight electron transport material is used. When a coating method using a coating solution is performed, a polymer binder may be used in combination. Examples of coating methods include methods exemplified for the hole injection layer 7.

### [Electron injection layer]

The electron injection layer 15 is disposed on a main surface (surface opposite to the surface in contact with the light emitting layer 11) of the electron transport layer 13. Regarding the material of the electron injection layer 15, known electron injection materials are used, and examples thereof include alkali metals, alkaline earth metals, and alloys containing one or more of alkali metals and alkaline earth metals, oxides, halides, and carbonates of alkali metals or alkaline earth metals, and mixtures of these substances. Examples of alkali metals and oxides, halides, and carbonates of alkali metals include lithium, sodium, potassium, rubidium, cesium, lithium oxide, lithium fluoride, sodium oxide, sodium fluoride, potassium oxide, potassium fluoride, rubidium oxide, rubidium fluoride, cesium oxide, cesium fluoride, and lithium carbonate. In addition, examples of alkaline earth metals and oxides, halides, and carbonates of alkaline earth metals include magnesium, calcium, barium, strontium, magnesium oxide, magnesium fluoride, calcium oxide, calcium fluoride, barium oxide, barium fluoride, strontium oxide, strontium fluoride, and magnesium carbonate.

A material obtained by mixing a conventionally known organic material having an electron transporting property and an organic metal complex of an alkali metal can also be used as an electron injection material.

The thickness of the electron injection layer 15 is, for example, 1 to 50 nm.

Examples of a method for forming the electron injection layer 15 include a vacuum deposition method.

### [Cathode layer]

The cathode layer 17 is disposed on a main surface (side opposite to the surface in contact with the electron transport layer 13) of the electron injection layer 15. Regarding the material of the cathode layer 17, for example, alkali metals, alkaline earth metals, transition metals and metals in Group 13 in the periodic table can be used. Regarding the material of the cathode layer 17, specifically, for example, a metal such as lithium, sodium, potassium, rubidium, cesium, beryllium, magnesium, calcium, strontium, barium, aluminum, scandium, vanadium, zinc, yttrium, indium, cerium, samarium, europium, terbium, and ytterbium, an alloy of two or more of the above metals, an alloy of one or more of the above metals and one or more of gold, silver, platinum, copper, manganese, titanium, cobalt, nickel, tungsten, and tin, or graphite or a graphite intercalation compound is used. Examples of alloys include magnesium-silver alloys, magnesium-indium alloys, magnesium-aluminum alloys, indium-silver alloys, lithium-aluminum alloys, lithium-magnesium alloys, lithium-indium alloys, and calcium-aluminum alloys.

In addition, for the cathode layer 17, for example, a transparent conductive electrode made of a conductive metal oxide, a conductive organic material, or the like can be used. Specific examples of conductive metal oxides include indium oxide, zinc oxide, tin oxide, ITO, and IZO, and examples of conductive organic materials include polyaniline and derivatives thereof, polythiophene and derivatives thereof. Here, the cathode layer 17 may have a structure in which two or more layers are laminated. Here, an electron injection layer may be used as the cathode layer 17.

The thickness of the cathode layer 17 is set in consideration of electrical conductivity and durability. The thickness of the cathode layer 17 is generally 10 nm to 10 µm, preferably 20 nm to 1 µm, and more preferably 50 nm to 500 nm. Examples of a method for forming the cathode layer 17 include a vacuum deposition method and a coating method.

### [Method for producing organic light-emitting diode]

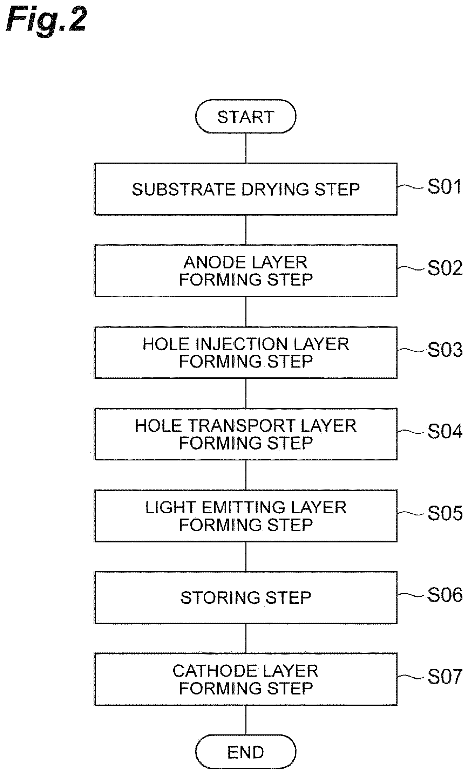

Subsequently, a method for producing the organic light-emitting diode 1 having the above configuration will be described with reference to FIG. 2.

In a form in which the support substrate 3 is a substrate which has flexibility and extends in the longitudinal direction, in the method for producing the organic light-emitting diode 1, a roll-to-roll method can be adopted. When the organic light-emitting diode 1 is produced by a roll-to-roll method, layers are sequentially formed from the side of the support substrate 3 while continuously transporting the long flexible support substrate 3 stretched between an unwinding roller and a winding roller by a transport roller.

When the organic light-emitting diode 1 is produced, as shown in FIG. 2, the support substrate 3 is heated and dried (substrate drying step S01). Next, the anode layer 5 is formed on the dried support substrate 3 (anode layer forming step S02). The anode layer 5 can be formed by the forming method exemplified in the description of the anode layer 5. Subsequently, the hole injection layer 7 and the hole transport layer 9 are formed on the anode layer 5 in this order (hole injection layer forming step S03, hole transport layer forming step S04). The hole injection layer 7 and the hole transport layer 9 can be formed by the forming method exemplified in the description of the hole injection layer 7 and the hole transport layer 9.

Next, the light emitting layer 11 is formed on the hole transport layer 9 (light emitting layer forming step (first forming step) S05). The light emitting layer 11 can be formed by the forming method exemplified in the description of the light emitting layer 11. Specifically, in the present embodiment, for example, the light emitting layer 11 is formed by a coating method using a coating solution in which a light-emitting material (including an organic material that emits fluorescence and/or phosphorescence) that forms the light emitting layer 11 is dissolved in an organic solvent.

Subsequently, a structure in which the light emitting layer 11 is formed is stored (storing step S06). In the present embodiment, the amount of light (hereinafter referred to as yellow light) emitted that does not include light having a wavelength range of 500 nm or less (a wavelength of 500 nm or less is blocked) emitted to the light emitting layer 11 is adjusted and thus the structure is stored. In the present embodiment, the structure is stored under a clean dry air atmosphere with a dew point temperature of -35°C or lower. In the storing step S06 of the present embodiment, the structure is stored in a range of 100 lx·hrs or more and 500,000 lx·hrs or less of an integrated illuminance (cumulative illuminance value) L·T[lx·hrs] which is a product of illuminance L[lx] of yellow light and an emission time T[hrs] of the yellow light.

The integrated illuminance is set according to a desired color temperature of the organic light-emitting diode 1. That is, the illuminance and emission time of yellow light are set according to the desired color temperature of the organic light-emitting diode 1. The color temperature of the organic light-emitting diode 1 increases as the integrated illuminance increases and decreases as the integrated illuminance decreases. For example, when the organic light-emitting diode 1 having a front luminance of 500 cd/m² or more and a color temperature at the front luminance of 3,000 K or higher is produced, it is stored under an environment in which the integrated illuminance is 1,750 lx·hrs or more and 500,000 lx·hrs or less. In this case, it is preferable that the illuminance L of yellow light be, for example, 50 lx or more and 1,000 lx or less, and the emission time T of yellow light be, for example, 35 hrs or more and 500 hrs or less.

For example, when the organic light-emitting diode 1 having a front luminance of 500 cd/m² or more and a color temperature at the front luminance of lower than 3,000 K is produced, it is stored under an environment in which the integrated illuminance is 1,680 lx·hrs or less. In this case, it is preferable that the illuminance L of yellow light be, for example, 10 lx or less, and the emission time T of yellow light be, for example, 50 hrs or more and 168 hrs or less. Here, in the storing step S06, an emission time during which yellow light is emitted may not be the same as a storage time. That is, a period during which the structure is stored may be a period during which no yellow light is emitted.

Subsequently, after the storing step S06, the cathode layer 17 is formed on the light emitting layer 11 (cathode layer forming step (second forming step) S07). The cathode layer 17 can be formed by the forming method exemplified in the description of the cathode layer 17. Therefore, the organic light-emitting diode 1 is formed. Here, a sealing member or the like may be provided on the cathode layer 17.

As described above, in the method for producing the organic light-emitting diode 1 according to the present embodiment, the integrated illuminance of yellow light which is a product of the illuminance of yellow light that is emitted to the light emitting layer 11 and the emission time of the yellow light is adjusted until formation of the cathode layer 17 starts after the light emitting layer 11 is formed. When yellow light is emitted to the hole transport layer 9 and the light emitting layer 11, properties (characteristics) of the layers change. In particular, properties of a red light-emitting component easily change due to yellow light. Due to the change in the properties, the luminance of a layer that emits red light (for example, the hole transport layer 9) can be reduced. Thereby, it is possible to increase the color temperature of the organic light-emitting diode 1. Thereby, in the method for producing the organic light-emitting diode 1, a color temperature can be adjusted by adjusting the integrated illuminance of yellow light without changing the film thickness of the light emitting layer 11 or changing a formulation proportion of an ink contained in the light emitting layer 11. Therefore, in the method for producing the organic light-emitting diode 1, it is possible to easily adjust the color temperature.

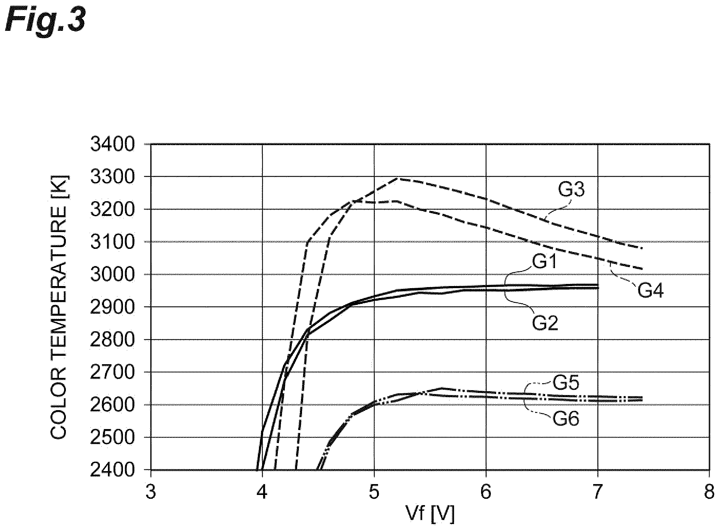

FIG. 3 is a diagram showing a relationship between a voltage and a color temperature. In FIG. 3, the abscissa represents voltage Vf [V], and the ordinate represents color temperature [K]. In FIG. 3, graphs G1 and G2 show the measurement results of the organic light-emitting diode in which the integrated illuminance of yellow light is not adjusted after the light emitting layer 11 is formed. Here, the unadjusted integrated illuminance of yellow light is less than 100 lx·hrs. Graphs G3 and G4 show the measurement results of the organic light-emitting diode when the illuminance of yellow light is 100 lx to 120 lx, the emission time is 168 hrs, and the integrated illuminance is 16,800 lx·hrs to 20,160 lx·hrs. Graphs G5 and G6 show the measurement results of the organic light-emitting diode when the illuminance of yellow light is 10 lx or less, the emission time is 168 hrs, and the integrated illuminance is 1,680 lx·hrs or less. FIG. 3 shows the measurement results of the organic light-emitting diode having a structure shown in FIG. 1, that is, an organic light-emitting diode in which an anode layer, a hole injection layer, a hole transport layer, a light emitting layer, an electron transport layer, an electron injection layer and a cathode layer are laminated on a support substrate.

As shown in FIG. 3, in a region in which the front luminance is 500 cd/m² or more, when the integrated illuminance is 16,800 lx·hrs to 20,160 lx·hrs, the color temperature is higher than that of the organic light-emitting diode in which the integrated illuminance of yellow light is not adjusted, and when the integrated illuminance is 1,680 lx·hrs or less, the color temperature is low. Specifically, when the integrated illuminance is 16,800 lx·hrs to 20,160 lx·hrs, the color temperature at the front luminance is 3,000 K or higher, and when the integrated illuminance is 1,680 lx·hrs or less, the color temperature at the front luminance is lower than 3,000 K (in FIG. 3, about 2,600 K). That is, it is confirmed that the color temperature increases as the integrated illuminance increases, and decreases as the integrated illuminance decreases. Therefore, in the method for producing the organic light-emitting diode 1, since the color temperature can be adjusted by adjusting the amount of yellow light emitted, it is possible to easily adjust the color temperature.

While embodiments of the present invention have been described above, the present invention is not necessarily limited to the above embodiments, and various modifications can be made without departing from the spirit and scope of the invention.

For example, the organic light-emitting diode 1 in which the anode layer 5, the hole injection layer 7, the hole transport layer 9, the light emitting layer 11, the electron transport layer 13, the electron injection layer 15 and the cathode layer 17 are disposed in this order has been exemplified in the above embodiment. However, the configuration of the organic light-emitting diode 1 is not limited thereto. The organic light-emitting diode 1 may have the following configuration.
(a) Anode layer/light emitting layer/cathode layer
(b) Anode layer/hole injection layer/light emitting layer/cathode layer
(c) Anode layer/hole injection layer/light emitting layer/electron injection layer/cathode layer
(d) Anode layer/hole injection layer/light emitting layer/electron transport layer/electron injection layer/cathode layer
(e) Anode layer/hole injection layer/hole transport layer/light emitting layer/cathode layer
(f) Anode layer/hole injection layer/hole transport layer/light emitting layer/electron injection layer/cathode layer
(g) Anode layer/hole injection layer/hole transport layer/light emitting layer/electron transport layer/electron injection layer/cathode layer
(h) Anode layer/light emitting layer/electron injection layer/cathode layer
(i) Anode layer/light emitting layer/electron transport layer/electron injection layer/cathode layer

Here, the symbol "/" indicates that layers between which the symbol "/" is interposed are laminated adjacent to each other. The above (g) shows a configuration of the above embodiment.

The organic light-emitting diode 1 may have one organic functional layer, or may have a plurality (two or more) of organic functional layers. In any one of the above (a) to (i) layer configurations, when a lamination structure disposed between the anode layer 5 and the cathode layer 17 is set as a "structural unit A," as a configuration of an organic light-emitting diode including two organic functional layers, for example, a layer configuration shown in the following (j) may be exemplified. Two layer configurations (structural unit A) may be the same as or different from each other. The charge generation layer is a layer that generates a hole and an electron when an electric field is applied. Examples of the charge generation layer include a thin film made of vanadium oxide, ITO, molybdenum oxide, or the like.
(j) Anode layer/(structural unit A)/charge generation layer/(structural unit A)/cathode layer

In addition, when "(structural unit A)/charge generation layer" is set as a "structural unit B," as a configuration of an organic light-emitting diode including two or more light emitting layers 11, for example, a layer configuration shown in the following (k) may be exemplified.
(k) Anode layer/(structural unit B)x/(structural unit A)/cathode layer

The symbol "x" denotes an integer of 2 or more, and "(structural unit B)x" denotes a structure in which x (structural units B) are laminated. In addition, a plurality of (structural unit B) layer configurations may be the same as or different from each other.

A plurality of organic functional layers may be directly laminated without providing the charge generation layer to form an organic light-emitting diode.

In the above embodiment, a form including the substrate drying step S01 in which the support substrate 3 is heated and dried in the step of producing the organic light-emitting diode 1 has been described as an example. However, the substrate drying step may not be included.

In the above embodiment, a form in which the anode layer 5 is formed on the support substrate 3 has been described as an example. However, a roller in which the anode layer 5 is formed on the support substrate 3 in advance may be used.

In the above embodiment, in the storing step S06, a form in which the structure is stored under an clean dry air atmosphere in which the dew point temperature is -35°C or lower has been described as an example. However, in the storing step, the structure may be stored under another atmospheric (for example, under a nitrogen atmosphere) environment in which the concentration of water is low.

In the above embodiment, a form in which the amount of yellow light emitted to the light emitting layer 11 is adjusted in the storing step S06 in the step of producing the organic light-emitting diode 1 has been described as an example. However, adjustment of the amount of yellow light emitted may be performed in a step other than the storing step as long as it is after the step of forming the light emitting layer 11.

In the above embodiment, a form in which the first electrode layer is the anode layer 5, and the second electrode layer is the cathode layer 17 has been described as an example. However, the first electrode layer may be a cathode layer, and the second electrode layer may be an anode layer.

In addition to the above embodiment, in the organic light-emitting diode 1, a light extraction film may be provided on the other main surface 3b of the support substrate 3.

In the above embodiment, a form in which, until formation of the cathode layer 17 starts after the light emitting layer 11 is formed, the integrated illuminance of yellow light which is a product of the illuminance of yellow light that does not include light having a wavelength range of 500 nm or less emitted to the light emitting layer 11 and the emission time of the yellow light is adjusted has been described as an example. However, the method for producing an organic light-emitting diode may have a form in which, until formation of the second electrode layer starts after the light emitting layer is formed, light having a wavelength range of 500 nm or less is not emitted to the light emitting layer. In this method, yellow light that does not have at least a wavelength range of 500 nm or less is emitted to the light emitting layer. When yellow light is emitted to the light emitting layer, properties (characteristics) of the layers change. In this case, due to the change in the properties, the luminance of a layer that emits red light can be reduced. Thereby, it is possible to increase the color temperature of the organic light-emitting diode. Therefore, also in the method for producing an organic light-emitting diode in another form, the color temperature can be adjusted without emitting light having a wavelength range of 500 nm or less without changing the film thickness of the light emitting layer or changing a formulation proportion of an ink contained in the light emitting layer. Therefore, in the method for producing an organic light-emitting diode, it is possible to easily adjust the color temperature.

In the above embodiment, the method for producing the organic light-emitting diode 1 has been described. However, the present invention may be a method for adjusting a color temperature. In the method for adjusting a color temperature, a color temperature of an organic light-emitting diode in which a first electrode layer, two or more organic functional layers including at least a light emitting layer and a second electrode layer are laminated in this order is adjusted. The first electrode layer, the light emitting layer and the second electrode layer correspond to the anode layer 5, the light emitting layer 11 and the cathode layer 17 in the organic light-emitting diode 1 of the above embodiment, respectively. In the method for adjusting a color temperature, until formation of the second electrode layer starts after the light emitting layer 11 is formed, the integrated illuminance of light which is a product of the illuminance of light that does not include light having a wavelength range of 500 nm or less emitted to the light emitting layer 11 and the emission time of the light is adjusted. Regarding a specific method, the same method as in the storing step S06 of the above embodiment can be adopted.

As described above, in the method for adjusting a color temperature, until formation of the second electrode layer starts after the light emitting layer is formed, the integrated illuminance of light which is a product of the illuminance of light that does not include light having a wavelength range of 500 nm or less emitted to the light emitting layer and the emission time of the light is adjusted. When yellow light is emitted to the light emitting layer (including another organic functional layer provided between the light emitting layer and the first electrode layer), properties (characteristics) of the layers change. In this case, due to the change in the properties, the luminance of a layer that emits red light can be reduced. Thereby, it is possible to increase the color temperature of the organic light-emitting diode. Therefore, in the method for adjusting a color temperature, the color temperature can be adjusted by adjusting the integrated illuminance of yellow light without changing the film thickness of the light emitting layer or changing a formulation proportion of an ink contained in the light emitting layer. Therefore, in the method for adjusting a color temperature, it is possible to easily adjust the color temperature.

The method for producing an organic light-emitting diode of the present invention can be defined as follows as a method using the method for adjusting a color temperature. That is, the method for producing an organic light-emitting diode is a method for producing an organic light-emitting diode including a first forming step of forming two or more organic functional layers including at least a light emitting layer on a first electrode layer and a second forming step of forming a second electrode layer on the organic functional layer, and the color temperature of the organic light-emitting diode is adjusted by the above method for adjusting a color temperature (method described in Claim 1 or 2).

### Reference Signs List

1 Organic light-emitting diode
5 Anode layer (first electrode layer)
9 Hole transport layer (organic functional layer)
11 Light emitting layer (organic functional layer)
13 Electron transport layer (organic functional layer)
15 Electron injection layer (organic functional layer)
17 Cathode layer (second electrode layer)

## Claims

1. A method for adjusting a color temperature which is a method for adjusting a color temperature of an organic light-emitting diode formed by a method including a first forming step of forming two or more organic functional layers including at least a light emitting layer on a first electrode layer and a second forming step of forming a second electrode layer on the organic functional layer,
wherein, until formation of the second electrode layer starts in the second forming step after the light emitting layer is formed in the first forming step, an integrated illuminance of light which is a product of an illuminance of light that does not include light having a wavelength range of 500 nm or less emitted to the light emitting layer and an emission time of the light is adjusted.

2. The method for adjusting a color temperature according to claim 1,
wherein the integrated illuminance is 100 lx·hrs or more and 500,000 lx·hrs or less.

3. A method for producing an organic light-emitting diode, comprising:
a first forming step of forming two or more organic functional layers including at least a light emitting layer on a first electrode layer; and
a second forming step of forming a second electrode layer on the organic functional layer,
wherein, until formation of the second electrode layer starts in the second forming step after the light emitting layer is formed in the first forming step, an integrated illuminance of the light which is a product of an illuminance of light that does not include light having a wavelength range of 500 nm or less emitted to the light emitting layer and an emission time of the light is adjusted.

4. The method for producing an organic light-emitting diode according to claim 3,
wherein the integrated illuminance is 100 lx·hrs or more and 500,000 lx·hrs or less.

5. A method for producing an organic light-emitting diode, comprising:
a first forming step of forming two or more organic functional layers including at least a light emitting layer on a first electrode layer; and
a second forming step of forming a second electrode layer on the organic functional layer,
wherein light having a wavelength range of 500 nm or less is not emitted to the light emitting layer until formation of the second electrode layer starts in the second forming step after the light emitting layer is formed in the first forming step.

6. The method for producing an organic light-emitting diode according to any one of claims 3 to 5,
wherein a dew point temperature of an atmosphere is -35°C or lower until formation of the second electrode layer starts in the second forming step after the light emitting layer is formed in the first forming step.

7. The method for producing an organic light-emitting diode according to any one of claims 3 to 6,
wherein an atmosphere is a dry air atmosphere until formation of the second electrode layer starts in the second forming step after the light emitting layer is formed in the first forming step.
